# EUROPEAN PATENT APPLICATION

(11) **EP 4 105 719 A1**
(43) Date of publication of application: **21.12.2022**
(21) Application number: 21179415.1
(22) Date of filing: 15.06.2021
(51) Int. Cl.: G03F 7/20, G06N 3/04

(54) **CAUSAL CONVOLUTION NETWORK FOR PROCESS CONTROL**

(71) Applicant: ASML Netherlands B.V., 5500 AH Veldhoven (NL)
(72) Inventor: WERKMAN, Roy, 5500 AH Veldhoven (NL); ROY, Sarathi, 5500 AH Veldhoven (NL)
(74) Representative: ASML Netherlands B.V.

(57) **Abstract**

A method for configuring a semiconductor manufacturing process, the method comprising: obtaining a plurality of first values of a first parameter based on successive measurements associated with a first operation of a process step in the semiconductor manufacturing process; using a causal convolutional neural network to determine a predicted value of a second parameter based on the first values; and using the predicted value of the second parameter in configuring a subsequent operation of the process step in the semiconductor manufacturing process.

## Description

### FIELD

The present invention relates to methods of determining a correction to a process, a semiconductor manufacturing processes, a lithographic apparatus, a lithographic cell and associated computer program products.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but are not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k₁.

International Patent Application WO 2015049087, which is incorporated by reference herein in its entirety, discloses a method of obtaining diagnostic information relating to an industrial process. Alignment data or other measurements are made at stages during the performance of the lithographic process to obtain object data representing positional deviation or other parameters measured at points spatially distributed across each wafer. Overlay and alignment residuals typically show patterns across the wafer, known as fingerprints.

In semiconductor manufacture, the Critical Dimension (CD) performance parameter fingerprint can be corrected using a simple control loop. Typically a feedback mechanism controls the average dose per wafer, using the scanner (a type of lithographic apparatus) as an actuator. Similarly, for the overlay performance parameter overlay, fingerprints induced by processing tools can be corrected by adjusting scanner actuators.

Sparse after-develop inspection (ADI) measurements are used as input for a global model used for controlling a scanner (typically run-to-run). Less-frequently measured dense ADI measurements are used for modelling per exposure. Modelling per exposure is performed for fields having large residual, by modelling with higher spatial density using dense data. Corrections that require such a denser metrology sampling cannot be done frequently without adversely affecting throughput.

It is a problem that model parameters based on sparse ADI data typically do not accurately represent densely measured parameter values. This may result from crosstalk that occurs between model parameters and non-captured parts of the fingerprint. Furthermore, the model may be over-dimensioned for such a sparse data set. This introduces a problem that a non-captured fingerprint in run-to-run control is not fully captured by a per-field model. Another problem is erratic sparse-to-dense behavior for distributed sampling, where different wafers (and different lots) have different sampling so that superposing the layouts of many wafers effectively leads to a dense measurement result. There are large residuals between modeled sparse data and densely measured parameter values. This leads to a poor fingerprint description, leading to sub-optimal corrections per exposure.

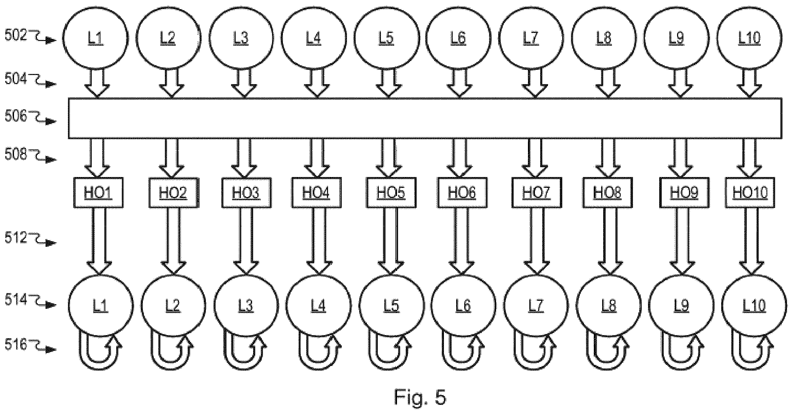

It is further a problem that for alignment control, only small number of alignment marks can be measured (-40) during exposure without impacting throughput. High-order alignment control requires denser alignment layout and impacts throughput. A solution to this problem, as shown in Figure 5 is to measure denser alignment marks in an offline tool (Takehisa Yahiro et. al., "Feed-forward alignment correction for advanced overlay process control using a standalone alignment station "Litho Booster"," Proc. SPIE 10585, Metrology, Inspection, and Process Control for Microlithography XXXII) and feed forward this high-order correction during exposure, where low-order corrections are still calculated during exposure.

For overlay control, dense overlay measurements can practically be performed only once in several lots (known as higher-order parameter update) to update the high-order correction. The high-order parameters used to determine the scanner control recipe do not change between higher-order parameter update measurements.

EP3650939A1, which is incorporated by reference herein in its entirety, proposes a method for predicting parameters associated with semiconductor manufacture. Specifically, a value of a parameter was measured using a sampling device, for each of a series of operations. The measured values are input successively to a recurrent neural network, which was used to predict a value of the parameter, and each prediction is used to control the next in the series of operations.

### SUMMARY

It is desirable to provide a method of determining a correction to a process, that solves one or more of the above-discussed problems or limitations.

While the use of a recurrent neural network represents an improvement over previously-known methods, it has been realized that advantages can be obtained using a different form of neural network, and in particular a neural network in which, to generate a prediction of a parameter at a present time, plural components of the input vector of the neural network represent values of a parameter (the same parameter or a different parameter) at a sequence of times no later than the present time. Such a neural network is referred to here as a neural network with "causal convolution".

Embodiments of the invention are disclosed in the claims and in the detailed description.

In a first aspect of the invention there is provided a method for configuring a semiconductor manufacturing process, the method comprising:
obtaining an input vector composed of a plurality of values of a first parameter associated with a semiconductor manufacturing process, the plurality of values of the first parameter being based on respective measurements performed at a plurality of respective first times of operation of the semiconductor manufacturing process;
using a causal convolution neural network to determine a predicted value of a second parameter at a second time of operation, no earlier than the first times, based the input vector; and
configuring the semiconductor manufacturing process using an output of the causal connection network.

In one case, the semiconductor manufacturing process may be configured using the predicted value of the second parameter (the "second parameter value"). However, alternatively, it may be configured using a further value output by the causal connection network, such as the output of a hidden layer of the causal connection network intermediate an input layer which receives the input vector and an output layer which outputs the predicted value of the second parameter. The output of the hidden layer may, for example, be input to an additional module (e.g. an adaptive module) configured to generate a control value of the semiconductor manufacturing process.

The first parameter may be the same as the second parameter, or may be different. In the first case, the method generates a prediction of the first parameter at the second time of operation, based on the measured values of the first parameter at the first times.

The step of configuring the semiconductor manufacturing process may comprise using the predicted value of the second parameter to determine a control recipe of a subsequent operation of the process step in the semiconductor manufacturing process.

Furthermore, the step of configuring the semiconductor manufacturing process may comprise using the predicted value to adjust a control parameter of the process.

In a second aspect of the invention there is provided a semiconductor manufacturing process comprising a method for predicting a value of a parameter associated with the semiconductor manufacturing process according to the method of the first aspect.

In a third aspect of the invention there is provided a lithographic apparatus comprising:
an illumination system configured to provide a projection beam of radiation;
a support structure configured to support a patterning device, the patterning device configured to pattern the projection beam according to a desired pattern;
a substrate table configured to hold a substrate;
a projection system configured the project the patterned beam onto a target portion of the substrate; and
a processing unit configured to:
   predict a value of a parameter associated with the semiconductor manufacturing process according to the method of the first aspect.

In a fourth aspect of the invention there is provided a lithographic cell comprising the lithographic apparatus of the third aspect.

In a fifth aspect of the invention there is provided a computer program product comprising machine readable instructions for causing a general-purpose data processing apparatus to perform the steps of a method of the first aspect.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of overlay sampling and control of a semiconductor manufacturing process;
- Figure 5 depicts a schematic overview of known alignment sampling and control of a semiconductor manufacturing process;

Figure 6 is composed of Figure 6(a) which depicts an environment in which a method which is an embodiment of the present invention is performed, and Figure 6(b) which is a schematic overview of a method of sampling and control of a semiconductor manufacturing process in accordance with an embodiment of the present invention.
- Figure 7 is a first causal convolution network for using an input vector of measured values of a first parameter for predicting the value of a second parameter according to a process according to an embodiment; and
- Figure 8 is a second causal convolution network for using an input vector of measured values of a first parameter for predicting the value of a second parameter according to a process according to an embodiment.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

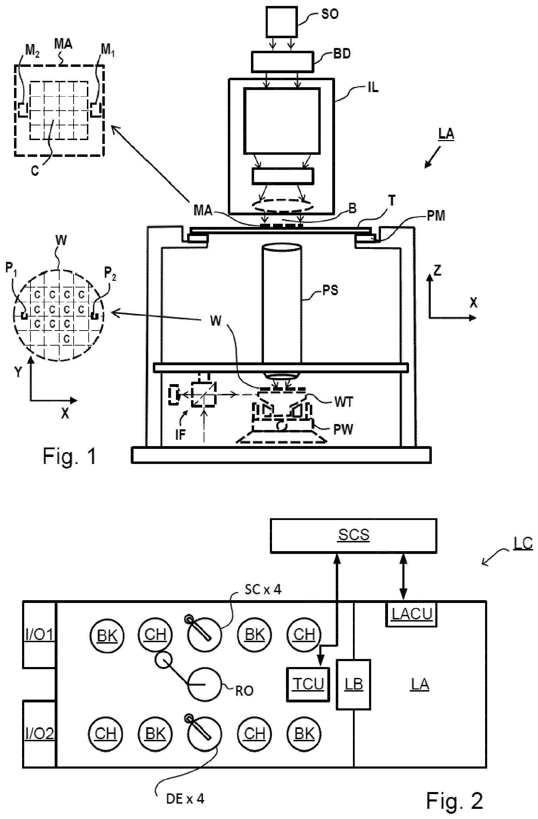

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

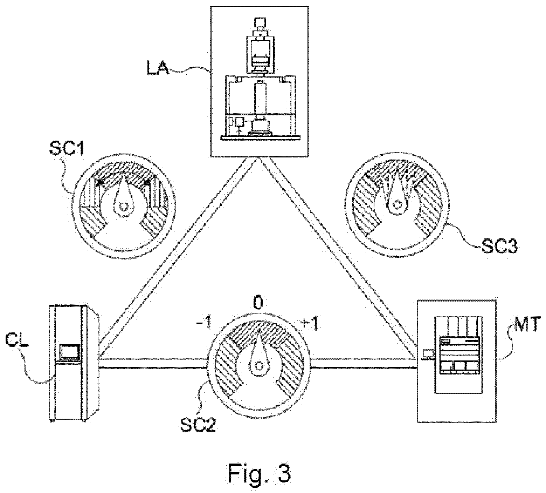

Typically, the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

### The use of causal convolution networks for configuring a semiconductor manufacturing process

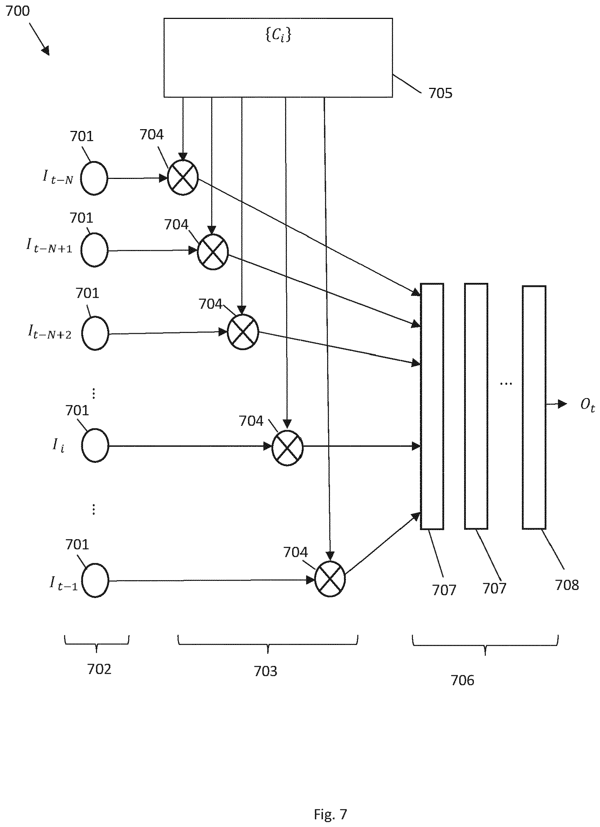

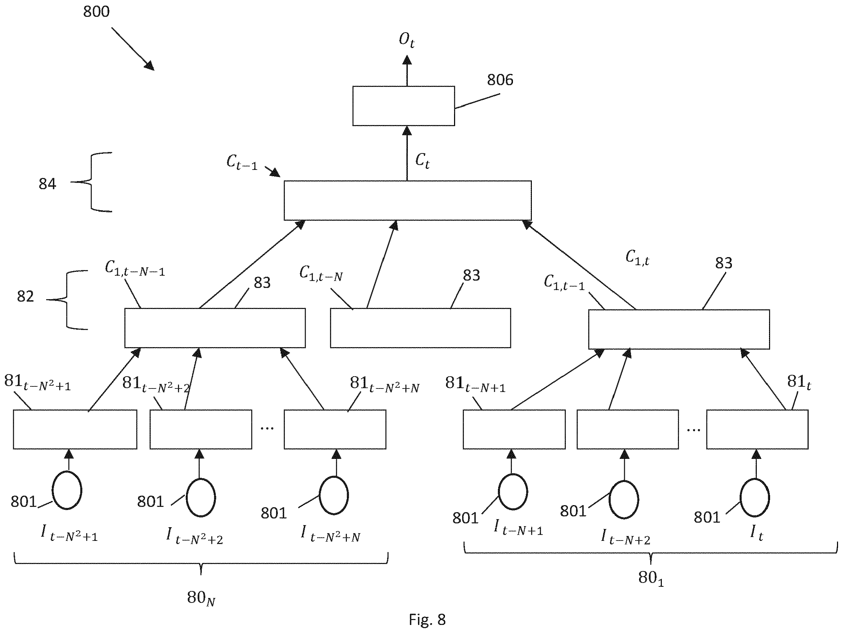

A causal convolution network is a neural network (adaptive system) which is configured, in each of successive times, to receive an input vector for each time which characterizes the values of at least one first parameter describing a process (in the present case, a semiconductor manufacturing process) at one or more earlier times, and obtain a prediction of the value of a second parameter (which may optionally be the first parameter) at the current time. Possible types of causal convolution network are described below, partly with reference to Figs. 7 and 8. First, we describe three applications of a causal convolution network for configuring a semiconductor manufacturing process.

### Causal convolution networks used in prediction of high order fingerprints

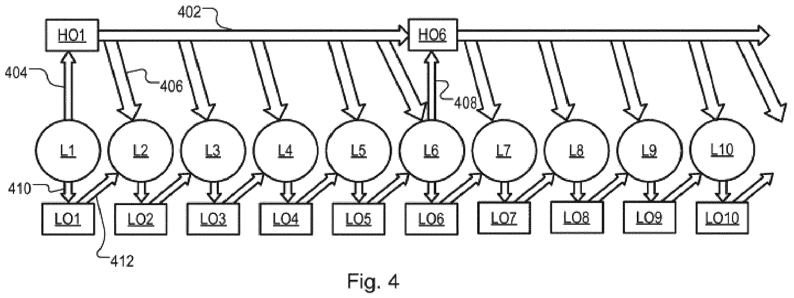

Figure 4 depicts a schematic overview of overlay sampling and control of a semiconductor manufacturing process. With reference to Figure 4, a sequence of ten operations L1 to L10 of an exposure process step on ten wafer lots (or batches, or wafers) are shown. These operations are performed at a plurality of respective times. A value of a high-order overlay parameter HO1 is obtained based on measurements 404 of the first lot L1 using a spatially dense sampling scheme. The high-order overlay parameter HO1 is used to configure the semiconductor manufacturing process, for example by determining control recipes 406 for subsequent exposures L2 to L6 of the next five lots. Then, an updated value of the high-order overlay parameter HO6 is obtained based on the earlier 402 high-order overlay parameter HO1 and based on measurements 408 of the sixth lot L6 using the spatially dense sampling scheme. In this example the higher-order parameter update repeats at the exposure of every fifth lot.

Meanwhile, for the exposure of every lot, low-order corrections are calculated per lot from sparse measurements. For example, at the exposure of lot L1 a low-order overlay parameter LO1 is obtained based on measurements 410 using a sparse sampling scheme, which is less spatially dense and more frequent than the spatially dense sampling scheme. The low-order parameter LO1 is used to configure the semiconductor manufacturing process, for example by determining the control recipe 412 of the subsequent operation L2 of the exposure step, and so on.

Thus, the low-order corrections are calculated per lot from sparse measurements, and high-order corrections are obtained from dense measurements once in several lots.

Figure 5 depicts a schematic overview of alignment sampling and control of a semiconductor manufacturing process. With reference to Figure 5, wafer lots L1 to L10 have an off-line alignment mark measurement step 502. The measurements 504 are performed by an off-line measurement tool, 506, which is optimized for off-line measurements with a high spatial sampling density. The measured high-order alignment parameter values 508 are stored HO1 to HO10 for each wafer lot L1 to L10. Then each high-order alignment parameter value is used to determine a control recipe 512 of the operation of an exposure step 514 on the corresponding wafer lot L1 to L10. The alignment parameter may be an EPE (edge placement error).

Meanwhile, for the exposure of every lot, low-order corrections are calculated per lot from sparse measurements. For example, at the exposure 514 of lot LI, a low-order alignment parameter 516 is obtained based on measurements using a sparse sampling scheme, which is less spatially dense than the spatially dense sampling scheme. It has the same frequency (per lot) as the offline dense measurements 504 of the high-order alignment parameters. The low-order parameter 516 is used to determine the control recipe of the operation L1 of the same exposure step.

Embodiments use a strategy for updating both overlay and alignment measurements in-between dense measurements using a causal convolution neural network. This improves the performance of alignment and overlay control with minimum impact on throughput. A completely independent causal convolution neural network prediction (no dense measurement required after training) is also possible, however it may diverge after some time if the learning becomes inadequate.

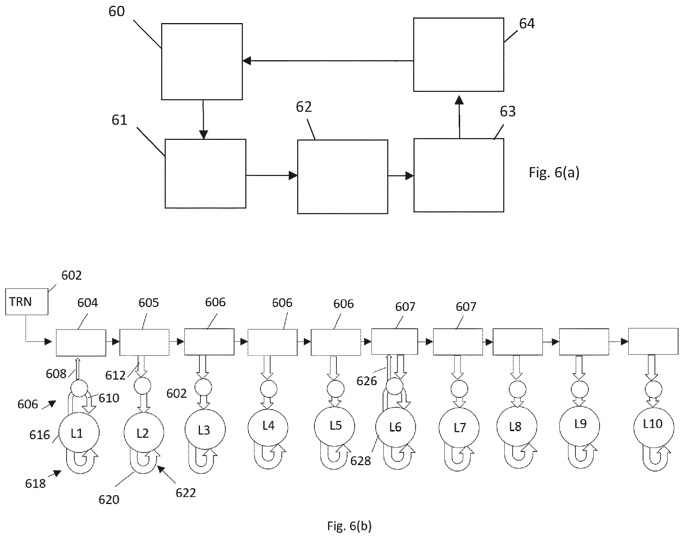

Figure 6(a) depicts an environment, such as a lithographic apparatus or an environment including a lithographic apparatus, in which a method of sampling and control of a semiconductor manufacturing process in accordance with an embodiment of the present invention is performed. The environment includes a semiconductor processing module 60 for performing semiconductor processing operations on successive wafer lots (substrates). The processing module 60 may for example comprise an illumination system configured to provide a projection beam of radiation; and a support structure configured to support a patterning device. The patterning device may be configured to pattern the projection beam according to a desired pattern. The processing module 60 may further comprise a substrate table configured to hold a substrate; and a projection system configured the project the patterned beam onto a target portion of the substrate.

The environment further includes a sampling unit 61 for performing a scanning operation based on a first sampling scheme. The scanning generates values of at least one first parameter characterizing the wafer lots. For example, the first sampling scheme may specify that a high-order parameter is measured for certain ones of the lots (e.g. one lot in every five) using a spatially dense sampling scheme, and that for other lots either no measurement is performed.

The environment further includes a memory unit 62 for storing the values output by the scanning unit 61, and at each of a number of times (time steps) generating an input vector including the stored values as the components (input values).

The environment further includes a neural network processing unit 63 for, at a given time, receiving the input vector. The neural network is a causal convolution neural network as described below. It outputs the second parameter value. Optionally, the second parameter can be the same as the first parameter, and the output of the neural network may be a predicted value of the high-order parameter in respect of wafer lots for which, according to the first sampling scheme, the sampling unit 61 generates no high-order parameter.

The environment further includes a control unit 64 which generates control data based on the second parameter value output by the neural network processing unit 63. For example, the control unit may specify a control recipe to be used in the next successive operation of the processing module 60.

Figure 6(b) depicts a schematic overview of a method of sampling and control of a semiconductor manufacturing process in accordance with an embodiment of the present invention.

With reference to Figure 6(b), updating of high-order parameters is achieved with prediction of in-between lots/wafers using a causal convolution neural network. This provides improved high-order correction for both alignment and overlay. The low-order corrections are measured per wafer, while the high-order corrections are predicted with the causal convolution neural network for in-between lots/wafers. The neural network is configured with an initial training (TRN) step 602.

Figure 6(b) depicts a method for predicting a value of a high-order parameter associated with a semiconductor manufacturing process. The method may be performed in an environment as shown in Fig. 6(a). In an example, the semiconductor manufacturing process is a lithographic exposure process. The first operation of the process is denoted L1. The sampling unit 61 measures a parameter which is the third-order scanner exposure magnification parameter in the y-direction, D3y. The method involves, prior to performing the operation LI, obtaining a value 608 of the high-order parameter based on measurements 606 (by a unit corresponding to the sampling unit 61 of Figure 6(a)) using a spatially dense sampling scheme. This is passed in step 604 to a memory unit (corresponding to the memory unit 62 of Figure 6(a)). The measured value 608 of the high-order parameter can be used directly to determine a control recipe 610 for processing of the measured lot in operation L1.

Additionally, a value 618 of a low-order parameter may be obtained based on measurements using a spatially sparse sampling scheme. The sparse sampling scheme is less spatially dense and more frequent than the high-order sampling scheme used for measurement 606. The value 618 of the low-order parameter may be alternatively or additionally be used to determine a control recipe for the operation L1. For example, it may be used to determine the control recipe 610 of the operation L1.

In a step 605, a processing unit (such as the processing unit 63 of Fig. 6(a)) is used to determine a predicted value 612 of the high-order parameter based on an input vector which comprises the measured value 608 of the high-order parameter obtained from measurement 606 at the first operation L1 of the process step in the semiconductor manufacturing process. The predicted value 612 is used to determine a control recipe 614 of a subsequent operation L2 of the process step in the semiconductor manufacturing process.

A value 620 of the low-order parameter may be obtained based on measurements performed on the same substrate supported on the same substrate table at which the subsequent operation L2 of the process step is performed. A control recipe 622 may be determined using the value 620 of the low-order parameter.

In each of a series of subsequent steps 606, the processing unit is used to determine a predicted value of the high-order parameter based on an input vector comprising the measured value 608 of the high-order parameter obtained from measurements 606. Optionally, it may further employ the low-order parameter values 618, 620.

Note that following the operation L5 and prior to the operation L6, a subsequent value 626 of the high-order parameter is obtained based on measurements 628 using the dense sampling scheme. This value also is passed to the memory unit 62, and at subsequent times used, together with the measured value 608, for form the input vector for the neural network processing unit 63, so that in subsequent steps 607 corresponding subsequent predictions of the high-order parameter are based on the values 608, 626 (and optionally on the low-order measurements also obtained according to the second sampling scheme). This process may be performed indefinitely, with an additional set of measurements using the dense sampling scheme being added after every five (or in a variation, any other number) operations.

Note that, in a variation, rather than performing all the steps 605, 606 based on the same input vector, the output of the neural network at step 605 may alternatively be used as the high-order parameter prediction to select the control recipe at all of steps L2 to L5. In other words, steps 606 may be omitted. In another variation, the neural network may be configured at step 605 to generate predictions for the high-order parameter at all of steps L2-L5 in a single operation of the neural network.

In this example, the semiconductor manufacturing process is a batch-wise process of patterning substrates. The sampling scheme for obtaining high-order parameters has a measurement frequency of per 5 (as shown in Figure 6(b)) to 10 batches. The second sampling scheme has a measurement frequency of one per batch. Although not shown in Figure 6, the method may be performed for a sequence of lots which is much greater than 10, such as at least 50, or over 100, with the input vector gradually accumulating the measured high-order parameters, so that the predictions the neural network makes become based on a large number of measured values. The input vector may have a maximum size, and once a number of measurements (in Figure 7 below denoted N) has been made which is higher than this maximum size, the input vector may defined to contain the most recent N measurements.

In this example, the semiconductor manufacturing process is a process of patterning substrates using exposure fields. The sampling scheme for obtaining high-order parameters has a spatial density of 200 to 300 measurement points per field and the sampling scheme for obtaining low-order parameters has a spatial density of 2 to 3 measurement points per field.

The method of predicting a value of a parameter associated with the semiconductor manufacturing process, as described with reference to Figure 6(b) may be implemented within a semiconductor manufacturing process. The method may be implemented in a lithographic apparatus with processing unit, such a LACU in Figure 2. It may be implemented in a processor in the supervisory control system SCS of Figure 2 or computer system CL of Figure 3.

The invention may also be embodied as a computer program product comprising machine readable instructions for causing a general-purpose data processing apparatus to perform the steps of a method as described with reference to Figure 6(b).

It is an advantage of the method of Figure 6(b) that for overlay no additional measurement is required, compared to the method of Figure 4. For alignment, only few wafers per lot are required to have spatially dense measurements, while all wafers receive different control recipes determined based on different high-order parameters. The in-between lots (for overlay) or wafers (for alignment) receive updated control recipes determined with high-order parameters predicted by the causal convolution neural network. Wafer table (chuck) matching is not required because the low-order measurements and corresponding control recipe update are performed on the same wafer table, for overlay and alignment parameters.

Embodiments provide a way to include high-order parameters into alignment correction without measuring each wafer. Embodiments also improve the methodology for updating overlay measurements.

### Causal convolution networks used to update parameters of a control model

Alternatively, or in addition, to using the method to update (higher-order) parameters the methods of the invention may be used to update parameters of a model used to update said parameters. Thus, the second parameter may not be a performance parameter, but rather a model parameter. For example run-to-run control of a semiconductor manufacturing process typically is based on determination of process corrections using periodically measured process (related) parameters. To prevent too large fluctuations of the process corrections often an Exponentially Weighted Moving Average (EWMA) scheme is applied to a set of historic process parameter measurement data, the set including more than just the last obtained measurements of the process parameter. The EWMA scheme may have a set of associated weighting parameters, one of them is the so-called "smoothing constant" λ. The smoothing constant dictates the extent to which measured process parameter values are used for future process corrections, or alternatively said; how far back in time measured process parameter values are used to determine current process corrections. The EWMA scheme may be represented by: *Zᵢ = λ* · *Xᵢ* + (1 - *λ*) · *Z*_{*i*-1}, wherein Zi-1 may for example represent a process parameter value previously determined as to be most suitable to correct run (typically a lot of substrates) 'i-1', Xi is the process parameter as measured for run 'i', and then Zi is predicted to represent a value of the process parameter to be most suitable to correct run 'i' (the run subsequent to run 'i-1').

More information on the use of EWMA in process control is provided for example in "Automated Process Control optimization to control Low Volume Products based on High Volume Products data, Proceedings of SPIE 5755, 17 may 2005, doi: 10.1117/12.598409", which is hereby included by reference in its entirety.

The value taken for the smoothing constant directly influences the predicted best process parameter used for determining process corrections for run 'i'. However process fluctuations may occur which may affect the optimal value of the smoothing constant (or any other parameter associated with a model for weighting historic process parameter data).

It is proposed to use the causal convolution neural network as described in previous embodiments to predict one or more values of a first parameter associated with a semiconductor manufacturing process based on historic measurement values of the first parameter. Instead of, or in addition to, determining a control recipe of a subsequent operation of a process step in the semiconductor manufacturing process it is proposed to update one or more parameters associated with the weighting model based on the predicted values of the first parameter. Said one more parameters may include the smoothing constant. The smoothing constant for example may be determined based on the level of agreement between the predicted values of the first parameter using the causal convolution neural network and values of the first parameter predicted using the weighting model (e.g. typically an EWMA based model). The weighting parameter (e.g. typically the smoothing constant) giving best agreement is selected. Periodic re-evaluation of the quality of the smoothing constant when benchmarked to prediction using the causal convolution neural network ensures optimal configuration of the EWMA model at any point in time. In a variation, the second parameter may be the smoothing parameter itself.

In an embodiment a method for predicting a value of a first parameter associated with a semiconductor manufacturing process is disclosed, the method comprising: obtaining a first value of the first parameter based on measurements using a first sampling scheme; using a causal convolution neural network to determine a predicted value of the first parameter based on the first value; determining a value of a parameter associated with a model used by a controller of a semiconductor manufacturing process based on the predicted value of the first parameter and the obtained first value of the first parameter.

In an embodiment the determining of the previous embodiment is based on comparing the predicted value of the first parameter with a value of the first parameter obtained by application of the model to the obtained first value of the first parameter.

### Causal convolution networks used to identify a fault in a processing component of a semiconductor manufacturing process

A third application of a causal convolution network is to identify a fault in a component of a semiconductor manufacturing process. For example, it may do this if the second parameter value is a value indicative of a component operating incorrectly, or more generally of an event (a "fault event") occurring in the semiconductor manufacturing process. Using the prediction of the second parameter output by the causal connection network, maintenance is triggered of equipment used in the semiconductor manufacturing process.

Consider for example a situation in which the process employs two scanning units located so as to expose respective faces of a semiconductor on respective sides of a manufacturer semiconductor item. The neural network may receive the output of measurements made of both faces of the semiconductor following the scanning over an extended period of time, and be trained to identify situations in which the operation of one of scanners has become faulty. The neural network may for example issue a warning signal which warns that one of the scanners has become faulty and that maintenance / repair is needed. The warning signal may indicate that the other scanner should be used instead.

In another case, the causal convolution network may predict the output of a device configured to observe and characterize the semiconductor item at a certain stage of the semiconductor manufacturing process. It is identified whether, according to a discrepancy criterion, there is a discrepancy between the prediction and the actual output of the device. It so, this discrepancy is an indication of a fault in the device, and is used to trigger a maintenance operation of the device.

### Specific forms of causal convolution networks

We now describe specific forms of causal convolution network which can be used in the methods above. A first such neural network 700 is illustrated in Fig. 7. The neural network 700 has an input layer 702, comprising a plurality of nodes 701. At a given current time, denoted here time *t*, the nodes 701 receive respective first parameter values {*I_{t-N}, I*_{*t-N*+1}, *I*_{*t-N*+2}, .... *I*_{*t-*1}} (that is, *Iᵢ* for *i = t* - *N,* ... *t* - 1), which describe a first parameter of a semiconductor manufacturing process at a plurality of times earlier than the current time. The neural network 700 in this case generates an output *Oₜ* which relates to the time *t. Oₜ* may for example be a prediction of the first parameter at the time t.

The causal convolution network includes an attention layer 703 which employs, for each node 701 in the input layer 702, a respective multiplication node 704. The multiplication node 704 for the *i*-th first parameter value, *Iᵢ,* forms the product of *Iᵢ* with the *i*-th component of an *N*-component weight vector, {*Cᵢ*}, stored in a memory unit 705. That is, there is an element-wise multiplication of the input vector {*Iᵢ*} and the weight vector {*Cᵢ*}. The values {*Cᵢ*} are "attention values", which have the function of determining to what extent information about the corresponding value *Iᵢ* of the first parameter is used later in the process. If *Cᵢ* = 0 for a given value of *i,* then no value about *Iᵢ* is used later in the process. Each of the values {*Cᵢ*} may be binary, that is 0 or 1. That is, they have the function of excluding information about times (if *Cᵢ* is zero for that value of *i*), but they do not change the size (relative importance) of the value *Iᵢ* for those *i* for which *Cᵢ* is non-zero. In this case the multiplication node 704 is called a "hard attention mode". Conversely, if the values {*Cᵢ*} may take real values (i.e. from a continuous range), the multiplication node is called a soft attention node, which only partially controls the transmission of the input values to the subsequent layers of the system 700.

The elementwise product of the input vector {*Iᵢ*} and the weight vector {*Cᵢ*} is used at the input to an adaptive component 706 which comprises an output layer 708 which outputs *Oₜ*, and optionally one or more hidden layers 707. At least one (and optionally all) of the layers 707 may be a convolutional layer, which generates a convolution to the input of the convolutional layer based on a respective kernel. During the training of the neural network 700, the values of the weight matrix {*Cᵢ*} are trained and preferably also corresponding variable parameters defining the hidden layers 707 and/or the output layer 708. For example, if one or more of the layers 707 are convolutional layers, the kernel of the convolutional layer may be adaptively modified in the training procedure.

Note that at each time, the value of *Iᵢ* at the N previous time-steps are used, so complete and unambiguous information about all of these steps is available. This is in contrast to a recurrent neural network of EP3650939A1, in which, at each time, information about much earlier times is only available in a form which has been repeatedly mixed with data concerning intermediate times.

Turning to Fig. 8, a second causal convolution network 800 is shown. In contrast to the causal convolution network of Fig. 7, the single attention layer 703 of the neural network 700, is replaced by a plurality of attention layers 82, 84 (for simplicity only two are shown, but further layers may be used). The input values are respective values of a first parameter *Iᵢ* at a respective set of *N*² times *i*=*t-N*²+1,...,t*.* They are supplied to an input layer of respective nodes 801.

Each value *Iᵢ* is supplied by the respective node 801to a respective encoder 81_{*t-N*₂+1},..., 81*ₜ* to generate an encoded value. Each encoder encodes the respective value of the first parameter based on at least one variable parameter, so there is a variable parameter per value of the first parameter, and these are used to generate *N*² respective encoded input values.

The *N*² input values are partitioned into *N* groups, each of *N* elements. A first such group of input values are the *Iᵢ* at a respective set of *N* times *i*=*t-N*+1,...,t*.* For an integer index *j*, which takes the values *j=1,...N,* the *j*-th such group is the input values *Iᵢ* at a respective set of *N* times *i*=*t-jN*+1,...,*t-N(j-1).* The respective encoded input values are partitioned accordingly.

A first attention layer 82 receives encoded values generated by the *N*² encoders 81_{*t-N*₂+1},..., 81*ₜ*. For each of the groups, there is provided a respective attention module 83. The attention module 83 multiplies the *N* encoded values of the corresponding group of input values by a respective attention coefficient. Specifically, the j-th group of encoded values are each individually multiplied by an attention coefficient denoted *C*_{*i,t*-*j*-1}. Thus, the set of attention values used by the first attention layer 82 runs from *C_{i,t}* to *C*_{*i,t-N*-1}*.* Each block 83 may output N values, each of them being a corresponding encoded value multiplied by the corresponding value of *C*_{*i*,*t-j-*1}.

A second attention layer 84 includes a unit which multiplies all the *N*² values output by the first attention layer 82 elementwise by a second attention coefficient *C*_{*t*-1}*,* so generate second attention values. The second attention values are input to an adaptive component 806, which may have the same structure as the adaptive component 706 of Fig. 7.

Training of the system 800 includes training the *N*² parameters of the encoders 81, the *N* parameters of the attention modules 83, and the parameter *C*_{*t*-1}, as well as the parameters of the adaptive component 806.

Several variations of Fig. 8 are possible. Firstly, it is possible for the encoders 81 to be omitted. However, the inclusion of the encoders 81 is preferred, since, as mentioned above, they provide at least one variable parameter for each of the input values.

Furthermore, although not shown in Fig. 8, the system 800 may comprise a decoder system receiving the output of the adaptive component 806 and generating from it a decoded signal. Thus, the system as a whole functions as an encoder-decoder system, of the type used for some machine translation tasks. The decoder system thus generates a time series of values for the second parameter.

The decoder system also may include attention layers, optionally with the same hierarchical system shown in Fig. 8. For example, a single third attention value may be multiplied with all the outputs of the attention module 806, and then the results may be grouped and each group be multiplied with a respective fourth attention value.

A third form of causal convolution network which can be employed in embodiments of the present invention is a "temporal convolutional neural network" as described in "An empirical evaluation of generic convolutional and recurrent networks for sequence modelling", Bai et al (2018), the disclosure of which is incorporated herein by reference. In general terms, a temporal convolutional neural network includes a plurality of 1-dimensional hidden layers arranged in a stack (that is, successively), in which at least one of the layers is a convolutional layer which operates on a dilated output of the preceding layer. Optionally, the stack may include a plurality of successive layers which are convolutional layers. As shown in Fig. 1 of Bai et al, the TCN uses causal convolutions, where the output at time *t* is generated from convolutions based on elements from time t and earlier in the preceding layer. Each hidden layer may be of the same length, with zero padding (in a convolutional layer, the amount of padding may be the kernel length minus one) being used to keep the output of the layers the same length. Thus, the outputs and inputs to each layer correspond to respective ones of the first times. Each component of the convolution is generated based on a kernel (with filter size *k*), based on *k* values from the preceding layer. These *k* values are preferably pairwise spaced apart in the set of first times by *d-1* positions, where *d* is a dilation parameter.

In the TCN, the stack of layers maybe employed in a residual unit which contains two branches: a first branch which performs an identity operation, and a second branch including the stack of layers. The outputs of the branches are combined by an addition unit which generates the output of the residual unit. Thus, the variable parameters of the second branch are trained during the training of the neural network to generate a modification to be made to the input to the residual unit to generate the output of the residual unit.

Another form of causal convolution network are the 2D convolutional neural networks discussed in "Pervasive Attention: 2D convolutional neural networks for sequence-to-sequence prediction", M Elbayad et al (2018), the disclosure of which is incorporated herein by reference. In contrast to an encoder-decoder structure, this employs a 2D convolutional neural network.

The various forms of causal convolution network have several advantages over known control systems. Some of its advantages over the RNN described in EP3650939A1 are as follows.

Firstly, a causal convolution network, such as a TCN, is less memory intensive. Accordingly, it is able to receive an input vector characterizing a larger number of lots (such as at least 100). Thus, the real-time control was able to employ a larger amount of measured data. It was surprisingly found that employing this number of lots led to better control of a semiconductor manufacturing process. Note that conventionally process control in the semiconductor manufacturing industry is still based on advanced weighted averaging of about the last 3 batches of wafers. While RNN-based methods make it possible to examine the last 10-20 batches, causal convolution networks, such as TCNs, make it possible to analyse a number of batches which may be above 50, such as 100 batches, or higher. Note that this comes at the cost of a considerably more complex network architecture which typically would also require a larger training set. This means that a person skilled in the art, with no understanding that there is any value in looking back by more than 10-20 batches, would not see the value of incurring this cost, and would thus not consider using a causal convolution neural network such as a TCN in a process control environment. When using a neural network that does more than simple weighted moving average (WMA) filtering, the more batches which are used the better, because that increases the chance that a certain effect will have occurred. These occurrences teach the system how to respond.

Secondly, in an RNN, the output of the RNN is fed back at each time as an input to the RNN for the next time, when the RNN also receives measured data relating to that time. This means that information about the distant past will be received by the RNN after it has passed through the RNN a large number of times. This leads to a phenomenon known as the "vanishing gradient problem" (by analogy with a similar problem encountered in multi-layer perceptrons), in which information about the distant times is lost due to noise in the nodes. In a causal convolution network, by contrast, the input vector for any time includes the measured first parameter values for earlier times, so this data is available to the causal convolution network in an uncorrupted form. Additionally, optionally input nodes may be included which relate to different parameters which may be from different external sources (such a different measurement devices) or may be output from another network. This means that important past events which happened long ago do not have to travel to the causal convolution neural network via the outputs of nodes at previous times. This prevents time delay and any probability that this information is lost due to noise.

Thus, as a causal convolution network according to the invention operates, starting at an initial time, the history available to it continuously grows. Typically, there is at least one variable parameter for each component of the input vector (input value), up to a maximum, so that number of parameters which are available in the causal convolution neural network grows also. In other words, the parameter space for defining the neural network grows.

A further advantage of a causal convolution network is that, due to its feed forward architecture, it may be implemented in a system which runs very rapidly. By contrast, RNNs have been found in practice to be slow, so that control of the semiconductor manufacturing process is delayed. Thus, the performance enhancement possible using a causal convolution network, surprisingly, has been found to be superior.

Finally, information about a semiconductor process may be optionally be obtained from the causal convolution neural network other than based on the second parameter values which it is trained to produce, based on a value output by the neural network other than the second prediction. That is, the neural network may be trained to predict the value of the second parameter, and this training causes the neural network to learn to encode critical information about the manufacturing process as hidden variables. These hidden variables can also be used to generate information about a third parameter (different from the second parameter), for example by feeding one or more hidden values to a further adaptive component which is trained to generate predictions of the third parameter. For example, in an encoder-decoder system of the type described above, where the encoder and decoder are trained together to predict values of the second parameter, the output of the encoder may be used (e.g. only) as an input to an adaptive module for generating information about the third parameter. This adaptive module may optionally be trained in parallel with the encoder-decoder, or afterwards.

### General definitions

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). It is also to be noted that the term metrology apparatus or metrology system encompasses or may be substituted with the term inspection apparatus or inspection system. A metrology or inspection apparatus as disclosed herein may be used to detect defects on or within a substrate and/or defects of structures on a substrate. In such an embodiment, a characteristic of the structure on the substrate may relate to defects in the structure, the absence of a specific part of the structure, or the presence of an unwanted structure on the substrate, for example.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of physical systems such as structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of a physical structure may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. With respect to the multi-sensitivity target embodiment, the different product features may comprise many regions with varying sensitivities (varying pitch etc.). Further, pitch p of the metrology targets is close to the resolution limit of the optical system of the scatterometer, but may be much larger than the dimension of typical product features made by lithographic process in the target portions C. In practice the lines and/or spaces of the overlay gratings within the target structures may be made to include smaller structures similar in dimension to the product features.

Further embodiments of the invention are disclosed in the list of numbered clauses below:
1. A method for configuring a semiconductor manufacturing process, the method comprising:
   obtaining an input vector composed of a plurality of values of a first parameter associated with a semiconductor manufacturing process, the plurality of values of the first parameter being based on respective measurements performed at a plurality of respective first times of operation of the semiconductor manufacturing process;
   using a causal convolution neural network to determine a predicted value of a second parameter at a second time of operation, no earlier than the latest of the first times, based on the input vector; and
   configuring the semiconductor manufacturing process using an output of the causal connection network.
2. The method of clause 1 in which the second time of operation is later than the first times.
3. The method of clause 1 or clause 2, in which the causal convolution neural network comprises, in order, an input layer configured to receive the input vector, one or more convolutional layers, and an output layer configured to output the predicted value of the second parameter.
4. The method of any preceding clause in which the causal convolution layer comprises at least one attention layer, which applies an element-wise multiplication to the input values or to respective encoded values based on the input values.
5. The method of clause 4, in which the first values are partitioned into a plurality of groups each including multiple input values, and there are a plurality of attention layers arranged in a hierarchical structure, a first attention layer out of the plurality of attention layers being arranged to multiply each group of the input values, or respective encoded values based on the input values of the group of the input values, by a respective attention coefficient, to obtain corresponding attention values.
6. The method of clause 5, in which a second attention layer is arranged to multiply the attention values obtained by the first attention layer by a second attention coefficient to generate second attention values.
7. The method of clause 1, in which the causal convolution network includes a plurality of convolutional layers configured with the input to each convolutional layer being an output of a preceding one of the layers, each output of the each layer being associated with a respective one of the plurality of first times, and, for each convolutional layer, being generated by applying a convolution based on a kernel to a plurality of outputs of the preceding layer which are associated with corresponding first times which are no later than the respective one of the first times.
8. The method of clause 7 in which the first times corresponding to the plurality of outputs of the preceding layer are spaced apart in the first times according to a dilation factor.
9. The method of clause 7 or clause 8 in which the stack of layers includes a plurality of successive convolutional layers.
10. The method of any preceding clause in which the second parameter is the same as the first parameter.
11. The method of clause 10, in which the first values of the first parameter include first values obtained using a first sampling scheme, the method further comprising using the predicted value of the first parameter to determine a control recipe of a subsequent operation of the process step in the semiconductor manufacturing process.
12. The method of clause 11, further comprising:- obtaining a value of a third parameter based on measurements using a second sampling scheme being less spatially dense and more frequent than the first sampling scheme; and - using the value of the third parameter to determine the control recipe of the subsequent operation of the process step.
13. The method of clause 12, wherein the value of the third parameter is obtained based on measurements at the subsequent operation of the process step.
14. The method of any of clauses 12 to 13, wherein the semiconductor manufacturing process is a batch-wise process of patterning substrates, and wherein the first sampling scheme has a measurement frequency of per 5 to 10 batches and the second sampling scheme has a measurement frequency of one per batch.
15. The method of any preceding clause, wherein the first parameter comprises an exposure magnification parameter and the process step comprises lithographic exposure.
16. The method of any preceding clause in which at least one of the first and second parameters is an overlap parameter or an alignment parameter.
17. The method of any preceding clause in which the second parameter is a parameter of a numerical model of the semiconductor manufacturing process, the method further including employing the predicted second parameter in the model, the configuring of the semiconductor manufacturing process being performed based on an output of model.
18. The method of clause 17 in which the model is an exponentially weighted moving average model, and the second parameter is a smoothing factor of the exponentially weighted moving average model.
19. The method of any of clauses 1 to 16 in which the second parameter is indicative of the occurrence of a fault event occurring in the semiconductor manufacturing process, the configuring the semiconductor manufacturing process comprising using the output of the causal connection network to trigger maintenance of equipment used in the semiconductor manufacturing process.
20. A semiconductor manufacturing process comprising a method for predicting a value of a parameter associated with the semiconductor manufacturing process according to the method of any preceding clause.
21. A lithographic apparatus comprising:- an illumination system configured to provide a projection beam of radiation;- a support structure configured to support a patterning device, the patterning device configured to pattern the projection beam according to a desired pattern;- a substrate table configured to hold a substrate;- a projection system configured the project the patterned beam onto a target portion of the substrate; and- a processing unit configured to: predict a value of a parameter associated with the semiconductor manufacturing process according to the method of any of clauses 1 to 19.
22. A computer program product comprising machine readable instructions for causing a general-purpose data processing apparatus to perform the steps of a method according to any of clauses 1 to 19.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

## Claims

1. A method for configuring a semiconductor manufacturing process, the method comprising:
obtaining an input vector composed of a plurality of values of a first parameter associated with a semiconductor manufacturing process, the plurality of values of the first parameter being based on respective measurements performed at a plurality of respective first times of operation of the semiconductor manufacturing process;
using a causal convolution neural network to determine a predicted value of a second parameter at a second time of operation, no earlier than the latest of the first times, based on the input vector; and
configuring the semiconductor manufacturing process using an output of the causal connection network.

2. The method of claim 1 in which the second time of operation is later than the first times.

3. The method of claim 1 or claim 2, in which the causal convolution neural network comprises, in order, an input layer configured to receive the input vector, one or more convolutional layers, and an output layer configured to output the predicted value of the second parameter.

4. The method of any preceding claim in which the causal convolution layer comprises at least one attention layer, which applies an element-wise multiplication to the input values or to respective encoded values based on the input values.

5. The method of claim 4, in which the first values are partitioned into a plurality of groups each including multiple input values, and there are a plurality of attention layers arranged in a hierarchical structure, a first attention layer out of the plurality of attention layers being arranged to multiply each group of the input values, or respective encoded values based on the input values of the group of the input values, by a respective attention coefficient, to obtain corresponding attention values.

6. The method of claim 5, in which a second attention layer is arranged to multiply the attention values obtained by the first attention layer by a second attention coefficient to generate second attention values.

7. The method of claim 1, in which the causal convolution network includes a plurality of convolutional layers configured with the input to each convolutional layer being an output of a preceding one of the layers, each output of the each layer being associated with a respective one of the plurality of first times, and, for each convolutional layer, being generated by applying a convolution based on a kernel to a plurality of outputs of the preceding layer which are associated with corresponding first times which are no later than the respective one of the first times.

8. The method of claim 7 in which the first times corresponding to the plurality of outputs of the preceding layer are spaced apart in the first times according to a dilation factor.

9. The method of claim 7 or claim 8 in which the stack of layers includes a plurality of successive convolutional layers.

10. The method of any preceding claim in which the second parameter is the same as the first parameter.

11. The method of claim 10, in which the first values of the first parameter include first values obtained using a first sampling scheme, the method further comprising using the predicted value of the first parameter to determine a control recipe of a subsequent operation of the process step in the semiconductor manufacturing process.

12. The method of any preceding claim in which at least one of the first and second parameters is an overlap parameter or an alignment parameter.

13. The method of any preceding claim in which the second parameter is a parameter of a numerical model of the semiconductor manufacturing process, the method further including employing the predicted second parameter in the model, the configuring of the semiconductor manufacturing process being performed based on an output of model.

14. The method of claim 13 in which the model is an exponentially weighted moving average model, and the second parameter is a smoothing factor of the exponentially weighted moving average model.

15. The method of any of claims 1 to 12 in which the second parameter is indicative of the occurrence of a fault event occurring in the semiconductor manufacturing process, the configuring the semiconductor manufacturing process comprising using the output of the causal connection network to trigger maintenance of equipment used in the semiconductor manufacturing process.
